Europäisches Patentamt

European Patent Office

Office européen des brevets

(19)

(11) Veröffentlichungsnummer: **0 615 250 A1**

## (12) EUROPÄISCHE PATENTANMELDUNG

(21) Anmeldenummer: **94102865.6**

(22) Anmeldetag: **25.02.94**

(51) Int. Cl.5: **G11C 19/18**, G11C 19/28, G09G 3/36

(30) Priorität: **08.03.93 DE 4307177**

(43) Veröffentlichungstag der Anmeldung:
**14.09.94 Patentblatt 94/37**

(84) Benannte Vertragsstaaten:
**FR GB NL**

(71) Anmelder: **Lüder, Ernst, Prof. Dr.-Ing. habil.**
**Institut für Netzwerk- und Systemtheorie,**
**Labor für Bildschirmtechnik,**
**Allmandring 3B**
**D-70550 Stuttgart (DE)**

(72) Erfinder: **Schleupen, Kai, Dipl.-Ing.**
**Brühlstrasse 37**
**D-70771 Leinfelden-Echterdingen (DE)**
Erfinder: **Lüder, Ernst, Prof. Dr.-Ing.**
**Allmandring 3B**
**D-70550 Stuttgart (DE)**

(74) Vertreter: **Möbus, Rudolf, Dipl.-Ing. et al**
**Dipl.-Ing. Rudolf Möbus,**
**Dr.-Ing. Daniela Möbus,**
**Dipl.-Ing. Gerhard Schwan,**
**Hindenburgstrasse 65**
**D-72762 Reutlingen (DE)**

(54) **Schaltungsanordnung zur Ansteuerung von ketten- oder matrixförmig angeordneten Schaltelementen.**

(57) Eine Schaltungsanordnung zur Ansteuerung von ketten- oder matrixförmig angeordneten Schaltelementen, die höchstens sieben Transistoren ($T_{n1}$, $T_{n2}$, $T_{n3}$, $T_{n4}$, $T_{n5}$, $T_{n6}$, $T_{n7}$) und höchstens zwei Kapazitäten ($C_{n1}$, $C_{nb}$) aufweist und von vier gegen einander um 90° phasenverschobenen Taktsignalen ($\Phi_1$, $\Phi_2$, $\Phi_3$, $\Phi_4$) gesteuert ist, um eine möglichst hohe Fertigungsausbeute zu erzielen. Die Transistoren ($T_{n5}$, $T_{n6}$, $T_{n7}$) zusammen mit einer Bootstrap-Kapazität ($C_{nb}$) bilden eine Ausgangsstufe (12). Mindestens ein weiterer Transistor bildet eine Lade und Entladestufe (II) für die Bootstrap-Kapazität.

FIG. 1

EP 0 615 250 A1

Die Erfindung betrifft eine Schaltungsanordnung als Teil eines Schieberegisters zur Ansteuerung von ketten- oder matrixförmig angeordneten Schaltelementen.

Eine Ansteuerung solcher ketten- oder matrixförmig angeordneter Elemente stellt insbesondere die Adressierung der Zeilen- und Spaltenleitungen eines Flüssigkristall-Bildschirms dar. Solche Aktiv-Matrix Flüssigkristall-Bildschirme (sogenannte AM-LCDs) werden in Zukunft im Fernseh- und Datenverarbeitungsbereich zunehmend Bildschirme mit Kathodenstrahlröhren ersetzen, da sie eine Vielzahl von Vorteilen aufweisen: geringes Gewicht, flache Bauweise, keine Verzerrung der darzustellenden Bilder, niedrige Ansteuerspannungen, geringer Leistungsverbrauch, die Möglichkeit als Lichtventil in einen Projektor eingesetzt zu werden, hohe Auflösung, keine Röntgenstrahlung wie bei der Elektronenstrahlröhre, keine starken magnetischen und elektrischen Felder am Bildschirm und die Herstellbarkeit in einer preiswerten Technologie, die sich auch für großflächige Anwendungen eignet. Flüssigkristall-Bildschirme bestehen aus einer matrixförmigen Anordnung von Bildpunkten, wobei jedem Bildpunkt ein Schaltelement zugeordnet ist. Die Schaltelemente sind vielfach Dünnfilmtransistoren. Die Bildinformation wird an die Spalten angelegt und zeilenweise über die Schaltelemente in die Bildpunktspeicher geschrieben. Daher müssen die Zeilen so angesteuert werden, daß jeweils nur eine Zeilenleitung der insgesamt N Zeilen des Bildschirms für 1/N-tel der Bildlaufzeit ein genügend hohes Potential besitzt, so daß die Bildpunktkapazität über das Schaltelement auf die der Bildinformation entsprechende Datenspannung aufgeladen werden kann. Es muß sichergestellt sein, daß sich die Bildpunktkapazität während der übrigen Bildwiederholzeit nicht über das Schaltelement entladen kann.

In vielen Anwendungen, wie zum Beispiel bei Bildschirmen mit hoher Bildpunktzahl und/oder kleiner Bildpunktgröße ist es vorteilhaft, die Schaltungsanordnung zur Ansteuerung der Zeilenleitungen auf dem Bildschirmsubstrat zu integrieren. Hierzu ist es erforderlich, daß die Schaltungsanordnung in derselben Technologie wie der Bildschirm herstellbar ist.

Aus der Literatur sind verschiedene Lösungen zur Integration von Schieberegistern zur Matrixadressierung in einem dem Bildschirmprozeß kompatiblen Herstellungsprozeß direkt auf dem Glassubstrat bekannt (Y. Oana et al.: 1984 SID Symposium Digest S. 312-315, S. Morozumi et al.: 1984 SID Symposium Digest S. 316-319, J. Ohwada et al.: Conf. Record of the 1988 inter. Res. Conf. S. 215-219, B. W. Faughnan et al.: Proc. of the SID Vol. 29/4 1988 S. 279-282, I. De Rycke et al.: Conf. Record of the 1988 inter. Res. Conf. S. 70-73, M.

Akiyama et al.: Japan Display 1986 S. 212-215, K. Khakzar et al.: Japan Display 1989 S. 438-441, Y. Nishihara et al.: 1992 SID Symposium Digest S. 609-612, Dae M. Kim et al.: 1990 SID Symposium Digest S. 304-306). Diese Treiberschaltungen bestehen aus einem N-stufigen Schieberegister und N Ausgangstreiberstufen, wobei N die Zahl der Zeilen des Flüssigkristall-Bildschirms ist. Die Ausgangsstufen müssen in der Lage sein, die zu treibende kapazitive Last, die sich aus den Eingangskapazitäten der Schaltelemente sowie den Überkreuzungskapazitäten der Zeilen- und Spaltenleitungen zusammensetzt, schnell zu laden und zu entladen.

Aus der Literatur ist sowohl die Verwendung statischer Schieberegister (Y. Oana et al.: 1984 SID Symposium Digest S. 312-315, S. Morozumi et al.: 1984 SID Symposium Digest S. 316-319, B. W. Faughnan et al.: Proc. of the SID Vol. 29/4 1988 S. 279-282, M. Akiyama et al.: Japan Display 1986 S. 212-215, Y. Nishihara 1992 SID Symposium Digest S. 609-612) als auch dynamischer Schieberegister (S. Morozumi et al.: 1984 SID Symposium Digest S. 316-319, J. Ohwada et al.: Conf. Record of the 1988 inter. Res. Conf. S. 215-219, i. De Rycke et al.: Conf. Record of the 1988 inter. Res. Conf. S. 70-73, K. Khakzar et al.: Japan Display 1989 S. 438-441) zur Adressierung der Zeilen- und Spaltenleitungen eines Bildschirms bekannt. Eine Stufe eines statischen Schieberegisters besteht im allgemeinen aus zwei bistabilen Kippstufen, die durch mindestens 12 Transistoren, beispielsweise in Dünnschichttechnik, realiert werden. Dynamische Schieberregisterstufen setzen sich aus zwei hintereinandergeschalteten Invertern zusammen und benötigen lediglich vier bis sechs Transistoren (4 Transistoren beispielsweise K. Khakzar Japan Display 1989 S. 438-441). Für die zusätzlich benötigten Ausgangstreiberstufen sind ebenfalls mehrere Lösungen bekannt. Eine einfache Lösung aus Y. Oana et al.: 1984 SID Symposium Digest S. 312-315 besteht lediglich aus zwei in Serie geschalteten Invertern. Als Ausgangstreiberstufe werden auch sogenannte Push-Pull-Stufen verwendet, die aus zwei breitkanaligen Dünnfilmtransistoren bestehen. Dem Schieberegister und der Push-Pull-Stufe werden mehrere Inverterstufen (siehe J. Ohwada et al.: Conf. Record of the 1988 inter. Res. Conf. S. 215-219, B. W. Faughnan et al.: Proc. of the SID Vol. 29/4 1988 S. 279 -282, M. Akiyama et al.: Japan Display 1986 S. 212-215) oder Verstärkerschaltungen (siehe J. Ohwada et al.: Conf. Record of the 1988 inter. Res. conf. S. 70-73) zwischengeschaltet. Nur jeweils ein Transistor der Push-Pull-Stufe ist leitend und verbindet den Ausgang entweder mit einem hohen oder einem niedrigen Potential.

Im Falle der Zeilenansteuerung erhöht sich die Gesamtzahl der benötigten Transistoren pro Zeilenansteuerstufe durch die Notwendigkeit zusätzlicher Ausgangsstufen um vier bis zwölf. Da Bildschirme mit großer Auflösung eine große Anzahl von Zeilen und Spalten aufweisen können (ca. 500-2000) sind hier also sehr umfangreiche Ansteuerschaltungen erforderlich. Dieselbe Problematik ergibt sich natürlich auch für die kettenförmige Anordnung von Schaltelementen, zum Beispiel den Schaltelementen zum Auslesen der Signale einer Bildsensorzeile oder der Ansteuerung von Schalttransistoren einer Druckerkopfzeile.

Der Erfindung liegt daher die Aufgabe zugrunde, eine Schaltungsanordnung, insbesondere zur Ansteuerung von Datenleitungen von Flüssigkristall-Bildschirmen, einfachen Aufbaus zu schaffen, um eine hohe Fertigungsausbeute zu erzielen.

Die Aufgabe wird mit einer Schaltungsanordnung der eingangs genannten Art erfindungsgemäß dadurch gelöst, daß sie höchstens 7 Transistoren und höchstens zwei Kapazitäten aufweist und von vier Taktsignalen, die jeweils um 90° gegeneinander phasenverschoben sind, gesteuert ist.

Bei der Adressierung einer Matrix bilden Schieberegister den Kern der Ansteuerung von Zeilen und Spalten. Für diese Form der Adressierung ist es in den meisten Fällen nicht erforderlich, beliebige Eingangsimpulsfolgen zuzulassen. Es genügt, einen Eingangsimpuls durch alle Stufen des Schieberegisters zu schieben, bevor der nächste Eingangsimpuls am Eingang der ersten Stufe anliegt. Aufgrund des Vier-Phasen-Taktes und der speziellen Eingangsimpulsfolge werden pro Schieberegisterstufe nur maximal sieben Transistoren und zwei Kapazitäten benötigt. Dabei kann in einer bevorzugten Ausführungsform ein Teil der Transistoren zusammen mit einer als Bootstrap-Kapazität wirkenden Kapazität eine Ausgangsstufe bilden und mindestens ein weiterer Transistor eine Lade- und Entladestufe für die Bootstrap-Kapazität bilden. Durch den Einsatz von Bootstrap-Kapazitäten in den Ausgangsstufen können mit der Schaltungsanordnung große Lastkapazitäten getrieben werden. In einer weiteren Variante kann die Schaltungsanordnung zur Erzielung eines hochohmigen Ausgangs der Schaltung zusätzlich einen aus einer weiteren Kapazität und zwei Transistoren gebildeten Inverter aufweisen. Dabei sind zweckmäßigerweise nie beide Transistoren gleichzeitig leitend, so daß kein statischer Querstrom fließt. Die Verlustleistung eines Schieberegisters mit einer solchen Schaltungsanordnung ist dann nur von der Schiebefrequenz abhängig. Weitere Vorteile ergeben sich, wenn sämtliche Transistoren der Schaltungsanordnung als Schalter wirken. Die Schaltung wird dadurch sehr störunempfindlich. Außerdem können die technologischen Abmessungen aller Transistoren dann ähnlich groß gewählt werden, was zu einer besseren Beherrschbarkeit des Herstellungsprozesses und somit zu einer höheren Fertigungsausbeute führt. Die Transistoren können dabei Feldeffekt-Transistoren vom n-MOS-Anreicherungstyp sein, wobei das Gate-Dielektrikum der Transistoren zweckmäßigerweise ein Isolator sein kann. Dies führt beim Anwendungsgebiet der großflächigen Dünnschichttechnik zu einem einfachen Herstellungsprozess und zu einer höheren Fertigungsausbeute. Besondere Vorteile einer erfindungsgemäßen Schaltungsanordnung ergeben sich bei ihrer Verwendung zur Ansteuerung von Zeilen- und/oder Spaltenleitungen von Flüssigkristall-Bildschirmen; sie ist jedoch nicht hierauf beschränkt.

Nachfolgend werden bevorzugte Ausführungsformen erfindungsgemäßer Schaltungsanordnungen anhand der Figuren näher erläutert.

Es zeigen:

Fig. 1  eine erste Ausführungsform einer erfindungsgemäßen Schaltungsanordnung für die n-te Stufe eines dynamischen Schieberegisters;

Fig. 2  Impulsdiagramme für die Schaltungsanordnung nach Fig. 1 bei einer Schiebefrequenz von 10 MHz;

Fig. 3  vier Stufen eines dynamischen Schieberegisters und deren Zuordnung zu den Vier-Phasen-Taktsignalen;

Fig. 4  die Verwendung der Schaltungsanordnung nach Fig. 1 für einen gegenimpulsfähigen Zeilentreiber;

Fig. 5  Impulsdiagramme für den gegenimpulsfähigen Zeilentreiber nach Fig. 4;

Fig. 6  die Verwendung einer zweiten Ausführungsform einer erfindungsgemäßen Schaltungsanordnung für ein Schieberegister ohne permanent niederohmigen Ausgang;

Fig. 7  Impulsdiagramme für die Schaltung nach Fig. 6;

Fig. 8  ein Schieberegister mit einem dritten Ausführungsbeispiel einer Schaltungsanordnung mit sehr kleiner Anzahl von Transistoren;

Fig. 9  Impulsdiagramme für die Schaltung nach Fig. 8;

Fig. 10  die Verwendung der Schaltungsstruktur nach Fig. 8 in einem Spaltentreiber für Flüssigkristall-Bildschirme mit Analogschaltern.

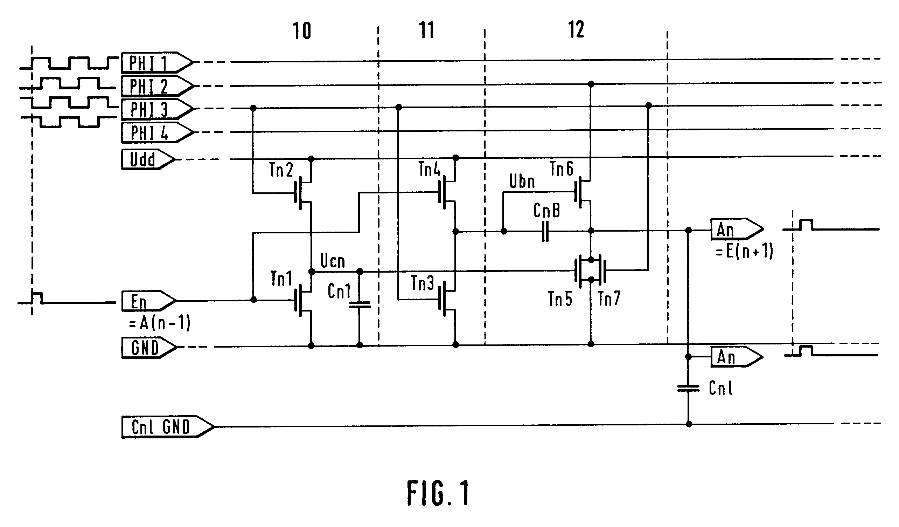

Fig. 1 zeigt ein Ausführungsbeispiel einer erfindungsgemäßen Schaltungsanordnung als n-te Stufe eines dynamischen Schieberegisters. Das Schieberegister wird von vier Taktsignalen $\Phi_1$, $\Phi_2$, $\Phi_3$ und $\Phi_4$ gesteuert, die an den Klemmen PHI1 - PHI4 anliegen und deren Verläufe links von den Klemmen PHI1 - PHI4 skizziert sind. Die Taktsignale $\Phi_1$ - $\Phi_4$ weisen jeweils eine Phasenverschiebung von 90° zueinander auf. Die Taktsignalpaare $\Phi_1/\Phi_3$ und $\Phi_2/\Phi_4$ überlappen sich also nicht, so daß keine Querströme in der Schaltungsanordnung auftreten. Außerdem wird die Schaltungsanordnung durch eine konstante Versorgungsspannung $U_{dd}$ versorgt.

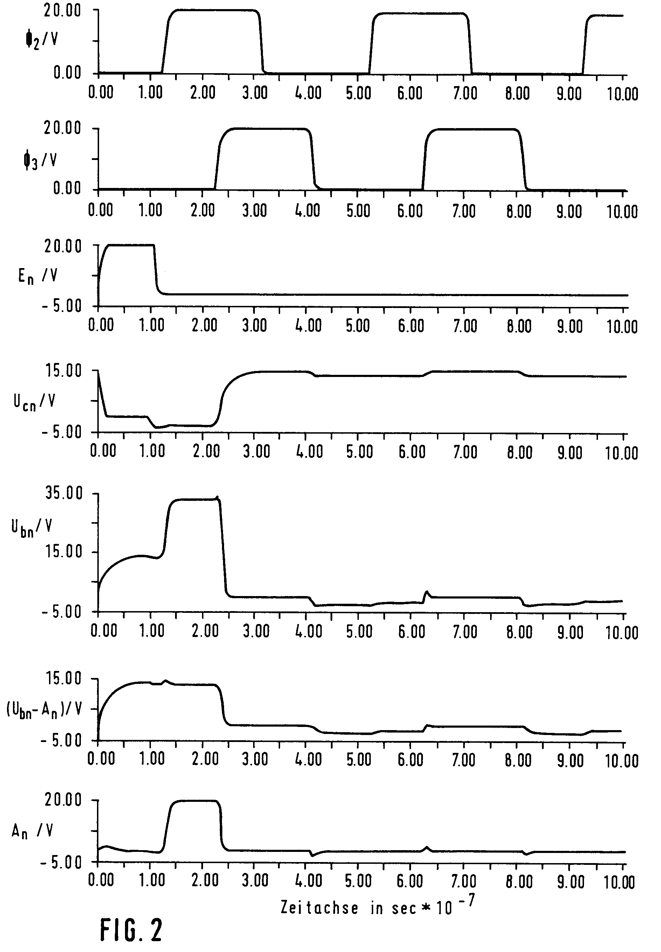

Die Schieberegisterstufe nach Fig. 1 ist in drei Teilstufen eingeteilt: eine Inverterstufe 10, eine Bootstrap-Kapazitäts-Lade- und Entladestufe 11 sowie eine Ausgangsstufe 12. Die Inverterstufe 10 besteht aus zwei Transistoren $T_{n1}$, $T_{n2}$ und der Kapazität $C_{n1}$. Der Transistor $T_{n2}$ lädt die Kapazität $C_{n1}$ während der hohen Pegel des Taktsignals $\Phi_3$ periodisch auf. Durch eine Wahl der Taktspannung $U_{\Phi3} > U_{dd} + U_{th}$, wobei $U_{th}$ die Schwellspannung der Transistoren ist, arbeitet der Transistor $T_{n2}$ im "Anlaufbereich" und lädt die Kapazität $C_{n1}$ daher sehr schnell auf die Spannung $U_{dd}$ auf. Die Entladung der Kapazität $C_{n1}$ erfolgt über den Transistor $T_{n1}$, wenn dieser durch ein Eingangssignal $E_n$ geschaltet wird. Dabei ist aus den Impulsdiagrammen nach Fig. 2 ersichtlich, daß die Signale $\Phi_3$ und $E_n$ nie gleichzeitig einen hohen Pegel aufweisen, um zu gewährleisten, daß $T_{n1}$ und $T_{n2}$ nie gleichzeitig leiten und infolgedessen nur sehr geringe Querströme, nämlich die Sperrströme der Feldeffekttransistoren, fließen. In den bisherigen Schieberegisterschaltungen mit Feldeffekttransistoren vom n-MOS-Anreicherungstyp, insbesondere bei denjenigen mit Zwei-Phasentakt, wird der Transistor $T_{n2}$ als Lastelement eingesetzt. Dazu werden Gate und Drain des Transistors $T_{n2}$ gemeinsam auf die Taktspannung gelegt, so daß der Transistor $T_{n2}$ ausschließlich in der "Sättigung" betrieben wird. Daraus folgt jedoch, daß bei den seitherigen Schieberegisterschaltungen die Speicherkapazität $C_{n1}$ nur auf eine Spannung $U_{C\infty} = U_{\Phi2} - U_{th}$ aufgeladen wird, die also eine Abhängigkeit von der Schwellspannung $U_{th}$ der Transistoren zeigt. Außerdem wird der Low-Ausgangspegel einer solchen herkömmlichen Inverterschaltung durch das Verhältnis der Quotienten von Kanallänge und Kanalbreite der Last- und Schalttransistoren bestimmt und ist daher immer größer als OV. Im Gegensatz dazu haben die Transistoren $T_{n1}$ und $T_{n2}$ der in Fig. 1 dargestellten Schaltung nur die Funktion eines Schalters, um die Speicherkapazität $T_{n1}$ zu laden bzw. zu entladen. Die Inverterausgangsspannung $U_{Cn}$ ist hier nicht von der Geometrie und der Schwellspannung $U_{th}$ der Transistoren $T_{n1}$ und $T_{n2}$ abhängig, wenn $U_{\Phi i} > U_{dd} + U_{th}$ gewählt wird. Lediglich die Flankensteilheit der Ausgangsimpulse von $U_{Cn}$ wird durch die Schwellspannung $U_{th}$ beeinflußt. Die Schaltsicherheit für nachfolgende Schieberegisterstufen wird damit wesentlich erhöht.

Die Bootstrap-Kapazitäts-Lade- und Entladestufe 11 besteht lediglich aus zwei Transistoren $T_{n3}$ und $T_{n4}$. über den Transistor $T_{n4}$ wird die Bootstrap-Kapazität $C_{nB}$ während eines hohen Pegels des Signals $E_n$ auf die konstante Spannung $U_{dd}$ aufgeladen. Dies wird dadurch gewährleistet, daß die Spannung $U_{dd}$ mindestens um die Schwellspannung $U_{th}$ kleiner als die Taktspannung $U_{\Phi i}$ ist und daß die Kanalbreite des Transistors $T_{n4}$ an die Größe der Kapazität $C_{nB}$ angepaßt ist. über den Transistor $T_{n3}$, der vom Taktsignal $\Phi_3$ angesteuert wird, wird die Bootstrap-Kapazität $C_{nB}$ wieder entladen. Es ist somit auch hier gewährleistet, daß nie beide Transistoren $T_{n3}$ und $T_{n4}$ gleichzeitig leiten.

Die Ausgangsstufe 12 besteht aus drei Transistoren $T_{n5}$, $T_{n6}$ und $T_{n7}$ sowie der Bootstrap-Kapazität $C_{nB}$. Durch die Aufladung der Kapazität $C_{nB}$ über den Transistor $T_{n4}$ wird der Transistor $T_{n6}$ leitend. Nach der Aufladung der Kapazität $C_{nB}$ bleiben die Transistoren $T_{n4}$ und $T_{n3}$ gesperrt, so daß die Gate-Source-Spannung am Transistor $T_{n6}$ aufgrund der geladenen Kapazität $C_{nB}$ konstant bleibt. Mit der steigenden Flanke von $\Phi_2$ steigt auch das Potential am Ausgang $A_n$ (vgl. Fig. 2). Gleichzeitig wird über $C_{nB}$ das Gate-Potential am Transistor $T_{n6}$ mitgekoppelt, was dazu führt, daß dieses Potential die Taktspannung $\Phi_2$ um die Ladespannung $U_{bn}$-$A_n{}^*$ an der Kapazität $C_{nB}$ übertrifft. Infolge hiervon wird der Kanal des Transistors $T_{n6}$ äußerst niederohmig, wodurch eine schnelle Aufladung einer am Ausgang der Ausgangsstufe 12 angeordneten Lastkapazität $C_{nL}$ gewährleistet ist. Mit dem Transistor $T_{n5}$ wird die Lastkapazität $C_{nB}$ entladen und der Ausgang niederohmig. Damit ist sichergestellt, daß keine eventuell eingekoppelten Störimpulse an die nächste Stufe des Schieberegisters weitergeschoben werden. Der zum Transistor $T_{n5}$ parallel geschaltete Transistor $T_{n7}$ wird direkt vom Taktsignal $\Phi_3$ angesteuert und hat die Aufgabe, die Steilheit der fallenden Flanke des Ausgangsimpulses $A_n$ zu erhöhen, um die überlappung der Ausgangsimpulse $A_n$ möglichst gering zu halten, damit nur geringe Querströme fließen.

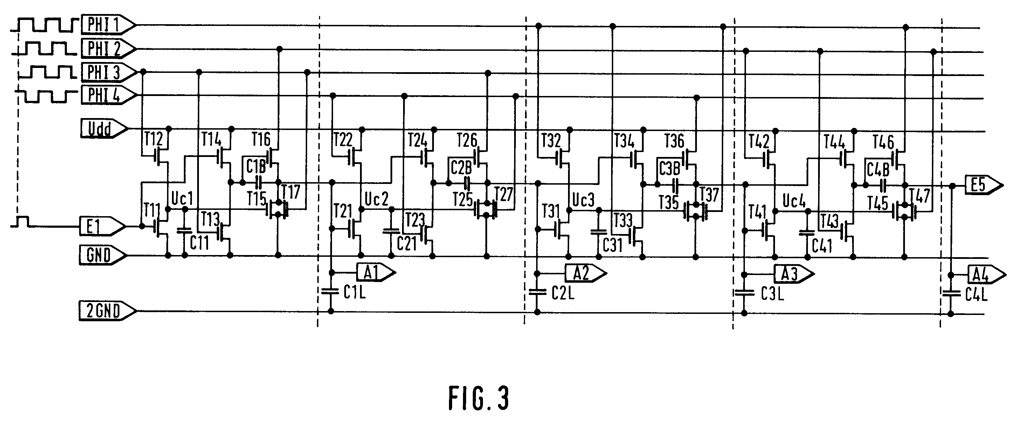

In Fig. 3 ist die Struktur eines Spaltenschieberegisters mit vier Stufen mit der Schaltungsanordnung nach Fig. 1 dargestellt, die sich aufgrund des Vier-Phasen-Taktes nach vier Stufen zyklisch wiederholt.

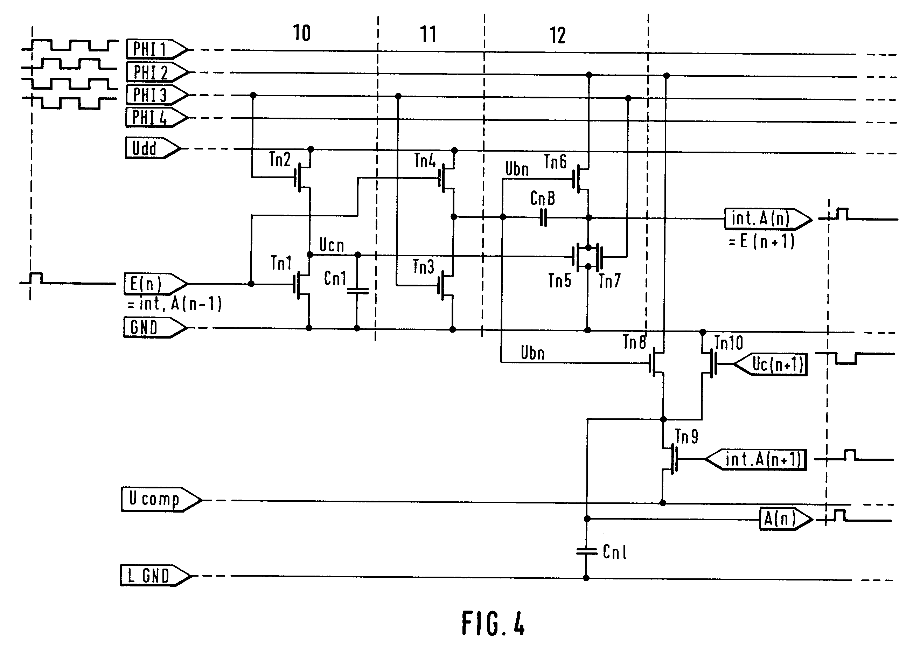

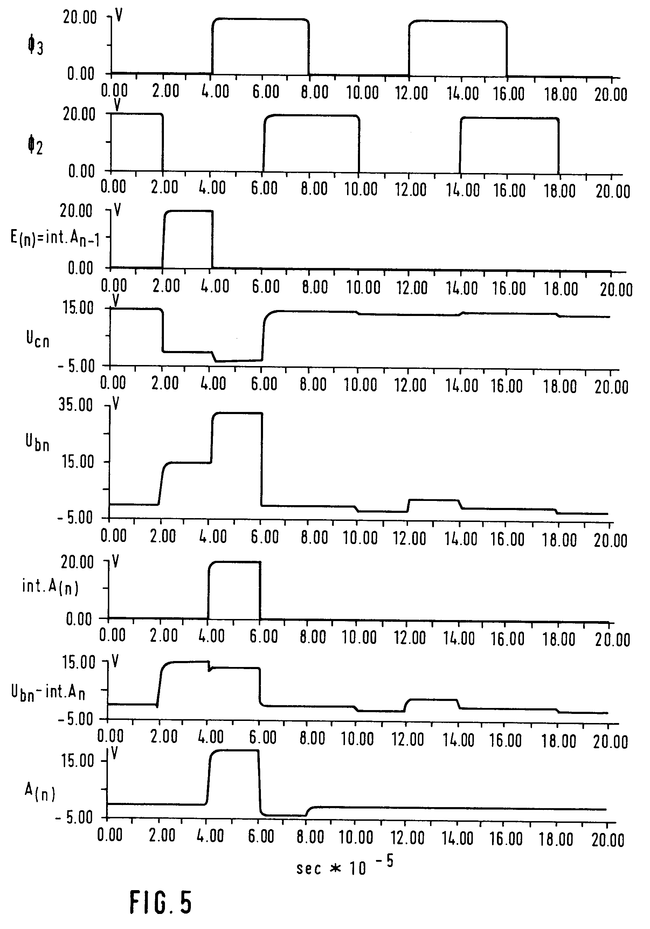

Zur Ansteuerung der Zeilen von Flüssigkristall-Bildschirmen werden Treiberschaltungen mit der Fähigkeit, hohe Lastkapazitäten anzusteuern, benötigt. Vor allem bei hochauflösenden aktiven Flüssigkristall-Bildschirmen können durch die hohe Anzahl von überkreuzungen zwischen Zeilen- und Spaltenleitungen Lastkapazitäten von über 100 pF am Ausgang eines Zeilentreibers auftreten. Außerdem benötigen Zeilentreiber für aktive Flüssigkristall-Bildschirme einen zu jedem Zeitpunkt niederohmigen Ausgang, um so zu verhindern, daß durch Überkoppeln über die Überkreuzungskapazitäten zwischen Spalten- und Zeilenleitungen Störimpulse auftreten, die zu einer ungewollten Ansteuerung von gerade nicht selektierten Bildschirmzeilen führen könnten. In Fig. 4 ist ein solcher Zeilentreiber dargestellt, der eine Schaltungsanordnung nach Fig. 1 aufweist. Es handelt sich hierbei um einen Zeilentreiber, der nicht nur einen Selektionsimpuls $A_{(n)}$ am Ausgang liefert, sondern zusätzlich nach dem Selektionsimpuls $A_{(n)}$ einen Gegenimpuls zur Kompensation kapazitiver Störungen in der aktiven Bildschirmmatrix. Dieses Prinzip der Kompensation ist aus der Literatur bereits bekannt (vgl. K. Suzuki, Eurodisplay 1987, S. 107-110, Y. Kaneko et al.: IEEE Transactions On Devices, Vol. 36, No. 12, 1989). Die Schaltungsanordnung mit den Bauelementen $T_{n1}, T_{n2}, T_{n3}, T_{n4}, T_{n5}, T_{n6}, T_{n7}, C_{n1}$ und $C_{nB}$ ist identisch zu der Schaltung nach Fig. 1. Wie aus Fig. 5 zu erkennen ist, gelten für die Ansteuersignale und die Signale innerhalb der Schaltung dieselben prinzipiellen Verläufe wie für die Schaltung nach Fig. 1. Für eine komplette Zeilentreiberstufe muß die Schaltung nach Fig. 1 lediglich um eine aus den drei Transistoren $T_{n8}, T_{n9}$ und $T_{n10}$ bestehende Zeilentreiberausgangsstufe erweitert werden. Für die gesamte Zeilentreiberstufe sind also nur zehn Transistoren erforderlich. Aus der Literatur sind bisher vergleichbare Zeilentreiberschaltungen nur mit mindestens 14 Transistoren pro Stufe bekannt.

Die Funktion der drei zusätzlichen Transistoren $T_{n8}, T_{n9}$ und $T_{n10}$ ist Fig. 4 und den Impulsdiagrammen in Fig. 5 zu entnehmen. Der Transistor $T_{n8}$ ist für die Durchschaltung des Selektionsimpulses mit der Amplitude von $\Phi_2$ zuständig, während der Transistor $T_{n9}$ einen Gegenimpuls durch Zuschalten einer Kompensationsspannung $U_{comp}$ erzeugt. Der Transistor $T_{n10}$ hält den Zeilentreiberausgang $A_{(n)}$ während der gesamten übrigen Zeit auf Masse-Potential (GND-Potential) (vgl. Fig. 5). Der Transistor $T_{n8}$, der für den Selektionsimpuls verantwortlich ist, erhält ebenso wie der Transistor $T_{n6}$ sein Gate-Steuersignal $U_{bn}$ von der Bootstrap-Kapazität $C_{nB}$. Das Gate des Transistors $T_{n9}$ wird vom internen Ausgangssignal $int.A_{(n+1)}$ der nachfolgenden Schieberegisterstufe angesteuert. Der Transistor $T_{n10}$ bezieht sein Gate-Steuersignal vom Ausgang $U_{c(n+1)}$ der Inverterstufe der nachfolgenden Schieberegisterstufe. Beide Transistoren $T_{n9}$ und $T_{n10}$ benötigen Signale aus der nächsten Schieberegisterstufe, so daß beim Bau des Zeilentreibers immer berücksichtigt werden muß, daß eine Schieberegisterstufe mehr vorhanden ist als Ausgänge erforderlich sind.

Die Kompensationsspannung $U_{comp}$ wird in der Regel sehr klein gewählt, kleiner als die Schwellspannung $U_{th}$ der Transistoren. Auch für die Zeilentreiberschaltung ist somit gewährleistet, daß sie, abgesehen von Umladeströmen und Leckströmen, nahezu querstromfrei ist.

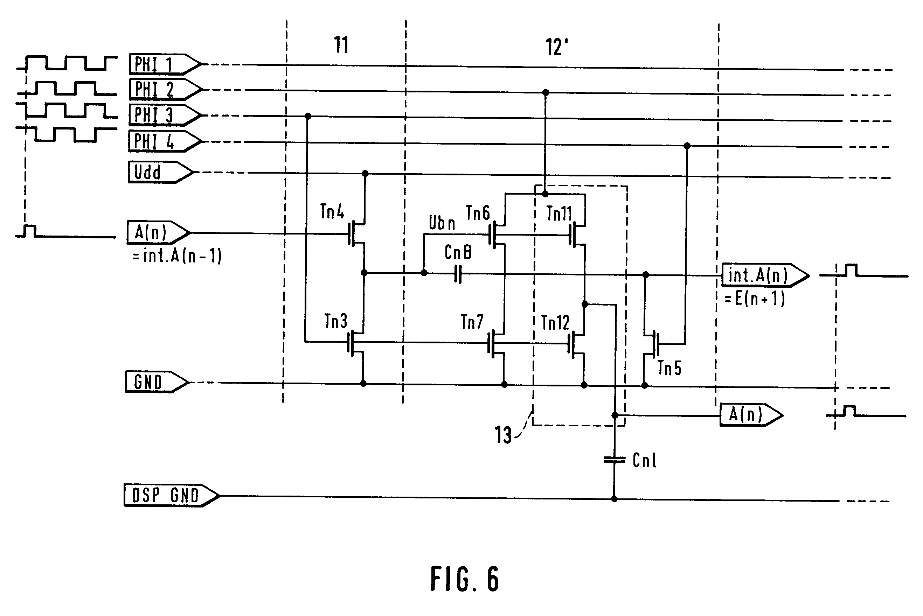

In vielen Anwendungsfällen ist es nicht erforderlich, daß der Schieberegisterausgang immer niederohmig ist. Dies ist beispielsweise dann nicht der Fall, wenn die kapazitiven Verhältnisse am Ausgang und die kapazitiven Kopplungen auf den Ausgang derart sind, daß sie nicht zu Störungen der Schiebefunktion des Schieberegisters führen können. In diesem Fall kann auf die Inverterstufe 10 der Schaltungsanordnung nach Fig. 1 verzichtet werden. Es können folglich zwei Transistoren und eine Kapazität eingespart werden, so daß der Flächenbedarf der Schaltungsanordnung abnimmt und sich die Fertigungsausbeute aufgrund der niedrigeren Zahl von Bauelementen erhöht. Fig. 6 zeigt diese Modifikation der Schaltungsanordnung nach Fig. 1 für Schieberegisteranwendungen. Dabei sind in den Fig. 1 und 6 gleiche Bauelemente mit gleichen Bezeichnungen versehen worden. Die Transistoren $T_{n3}$ und $T_{n4}$ bilden wieder eine Bootstrap-Kapazitäts-Lade- und Entladestufe 11 und die Transistoren $T_{n6}, T_{n7}, T_{n5}, T_{n11}$ und $T_{n12}$ sowie die Kapazität $C_{nB}$ bilden eine interne Ausgangsstufe 12' mit einer entkoppelnden Ausgangsstufe 13 zu einem Videotreiber. Das Gate des Transistors $T_{n5}$ kann nun nicht mehr an den Inverterausgang angeschlossen werden und wird daher mit dem Taktsignal $\Phi_4$ verbunden. Die Transistoren $T_{n5}$ und $T_{n7}$ gewährleisten somit, daß der interne Ausgang $int.A_{(n)}$ mit Ausnahme des Taktsegments, in dem ein Ausgangsimpuls zu erwartet ist, niederohmig ist. Dabei besteht die Schieberegisterschaltung nach Fig. 6, die sich aus der Lade- und Entladestufe 11 und der Ausgangsstufe 12' zusammensetzt, insgesamt aus nur 5 Transistoren ($T_{n3}, T_{n4}, T_{n5}, T_{n6}$ und $T_{n7}$) und einer Kapazität ($C_{nB}$). Zur Entkopplung der aus den Transistoren $T_{n5}, T_{n6}$ und $T_{n7}$ bestehenden Ausgangsstufe wird eine Ausgangsstufe 13, die von den Transistoren $T_{n11}$ und $T_{n12}$ gebildet wird, eingesetzt. Die entkoppelnde Ausgangsstufe 13 wird mit den gleichen Signalen versorgt wie die Transistoren $T_{n6}$ und $T_{n7}$ (vgl. Fig. 6). Die Entkopplung bietet den Vorteil, daß Schwankungen der Ausgangslast das interne Ausgangssignal $int.A_{(n)}$ nur unwesentlich beeinflussen.

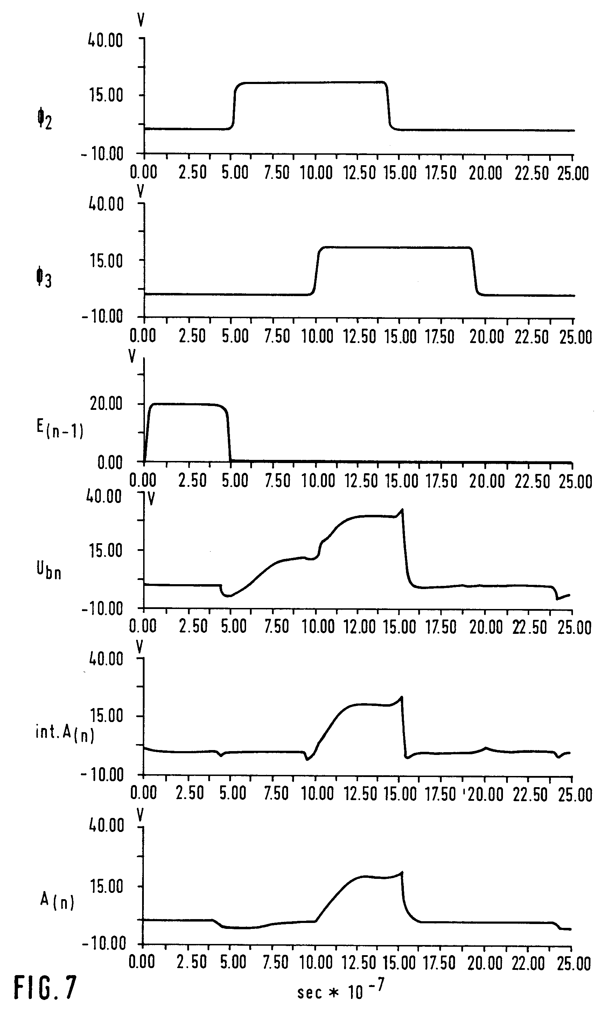

Die Taktzuordnungen für die weiteren nachfolgenden Stufen erfolgen analog der in Fig. 3 dargestellten Weise. Die Impulsdiagramme der Schaltungsstruktur aus Fig. 6 sind in Fig. 7 dargestellt. Sie unterscheiden sich in ihrem prinzipiellen Verlauf nur geringfügig von denen aus Fig. 2. Der Unterschied besteht in erster Linie in einem Zeitintervall, das durch die Hochohmigkeit der Ausgangsknoten gekennzeichnet ist.

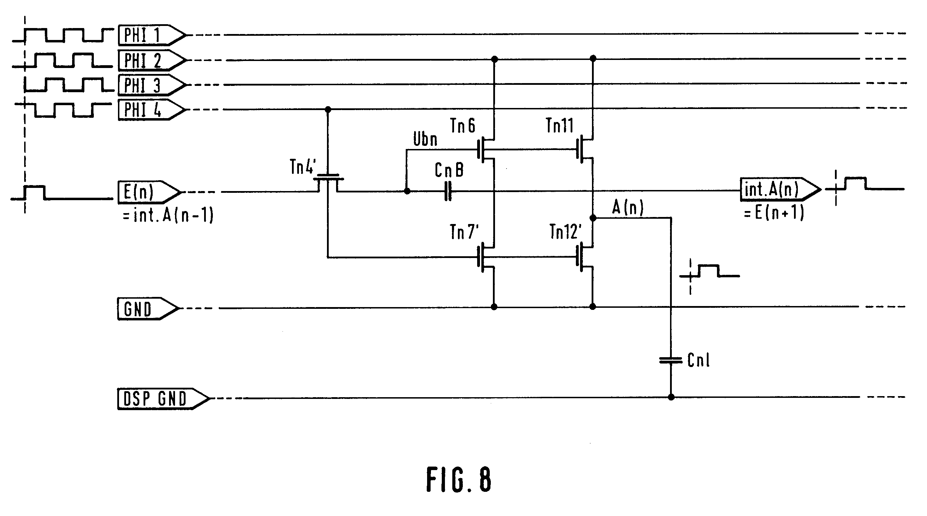

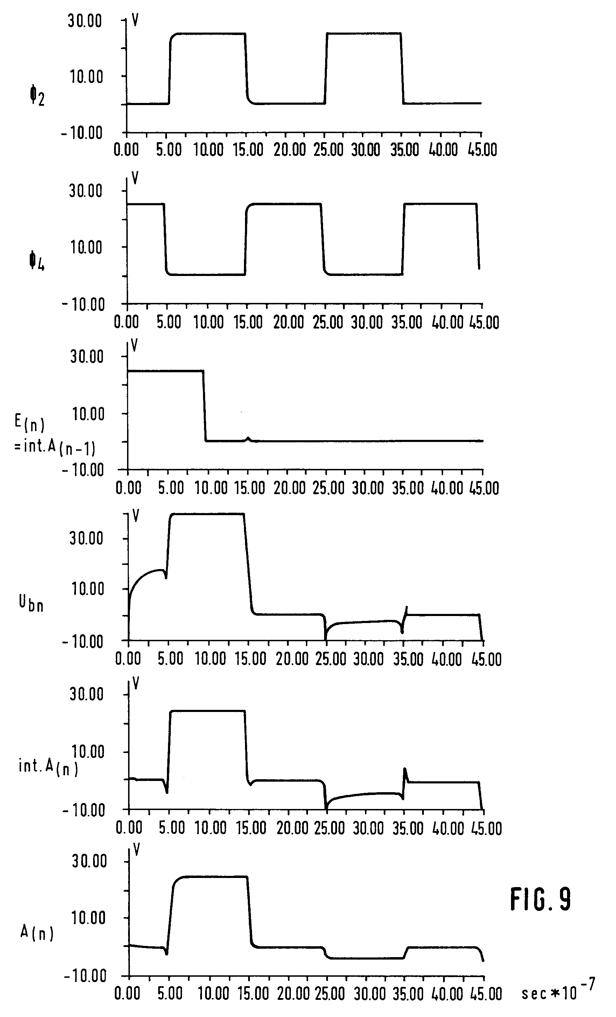

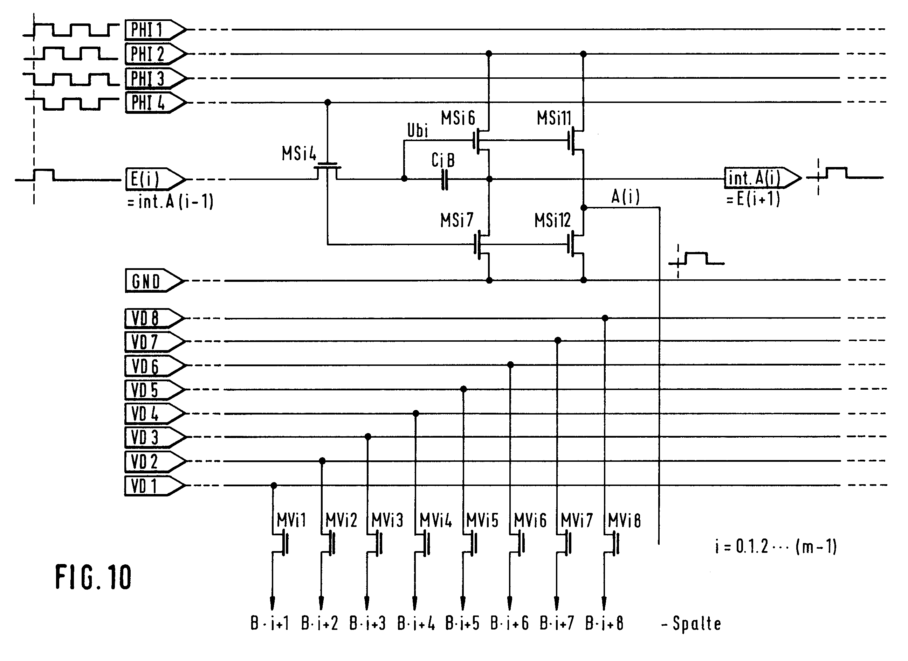

Ausgehend von der modifizierten Schaltung nach Fig. 6 ergibt sich die Schaltungsstruktur in Fig. 8, die mit einer Minimalzahl von Transistoren pro Schieberegisterstufe auskommt. Die Taktversorgungssignale sind identisch mit denen der Schaltung nach Fig. 6. Die konstante Spannung $U_{dd}$ wird bei der Schaltung nach Fig. 8 nicht benötigt, da die aus den Transistoren $T_{n3}$ und $T_{n4}$ in Fig. 6 gebildete Bootstrap-Lade- und Entladestufe 11 durch einen einzigen Transistor $T_{n4}'$ ersetzt werden kann. Das Gate dieses Transistors $T_{n4}'$ wird nun außerdem vom Taktsignal $\Phi_4$ und nicht mehr vom Taktsignal $\Phi_3$ angesteuert. Die eigentliche Schiebefunktion des Schieberegisters wird ausschließlich durch die drei Transistoren $T_{n4}'$, $T_{n6}'$ und $T_{n7}'$ gewährleistet. Die Transistoren $T_{n11}$ und $T_{n12}'$ stellen die entkoppelte Ausgangstreiberstufe des Schieberegisters dar. Die Funktion des Schieberegisters ist prinzipiell die gleiche wie bei der Schieberegisterstruktur nach Fig. 6. Die Besonderheit des Schieberegisters nach Fig. 8 besteht in den überlappenden Ausgangssignalen $A_{(n-1)}$ und $A_{(n)}$, wie in Fig. 9 aus den Impulsdiagrammen der Signale $E_{(n)}$-[$= A_{(n-1)}$] und $A_{(n)}$ zu ersehen ist. Für die Zeilentreiber zur Ansteuerung von Flüssigkristall-Bildschirmen ist ein Schieberegister nach Fig. 8 wegen der überlappenden Ausgangsimpulse und der hochohmigen Zustände am Ausgang nicht geeignet, wohl aber zum Einsatz in einem Spaltentreiber. Fig. 10 zeigt die einfachste Art eines solchen Spaltentreibers für einen Flüssigkristall-Bildschirm mit Analogschaltern MVi1 - MVi8, die nacheinander und gruppenweise, wobei hier acht Spalten zu einer Gruppe zusammengefaßt sind, von einem Schieberegister nach dem Typ aus Fig. 8 geöffnet werden und die analoge Videoinformation auf die Spalten schreiben. Anstelle des Schieberegisters nach Fig. 8 könnte natürlich auch ein Schieberegister mit einer Schaltungsanordnung nach Fig. 1 oder Fig. 6 eingesetzt werden. Die Schaltungsanordnung nach Fig. 8 bietet jedoch den Vorteil, daß gerade die Eigenschaft der sich überlappenden Ausgangsimpulse $A_{(n-1)}$ und $A_{(n)}$ gut dazu verwendet werden kann, die Selektionszeiten der Analogschalter MVi1 bis MVi8 wegen der nun insgesamt doppelt so breiten Ausgangsimpulse zu erhöhen. Dies bietet den Vorteil, daß die doppelte Zeit zur Verfügung steht, um die kapazitätsbehaftete Spalte des Flüssigkristall-Bildschirms zu laden.

Die beschriebenen Schaltungen eignen sich für die in der Dünnschichttechnik üblichen amorphen und polykristallinen Halbleitermaterialien, zum Beispiel a-Si:H für amorphe und poly-Si bzw. CdSe für polykristalline Halbleitermaterialien.

**Patentansprüche**

1. Schaltungsanordnung als Teil eines Schieberegisters zur Ansteuerung von ketten- oder matrixförmig angeordneten Schaltelementen, dadurch gekennzeichnet, daß sie höchstens sieben Transistoren ($T_{n1}$, $T_{n2}$, $T_{n3'}$ $T_{n4'}$ $T_{n5'}$ $T_{n6'}$ $T_{n7}$) und höchstens zwei Kapazitäten ($C_{n1}$, $C_{nB}$) aufweist und von vier Taktsignalen ($\Phi_1$, $\Phi_2$, $\Phi_3$, $\Phi_4$), die jeweils um 90° gegeneinander phasenverschoben sind, gesteuert ist.

2. Schaltungsanordnung nach Anspruch 1, dadurch gekennzeichnet, daß ein Teil der Transistoren ($T_{n5}$, $T_{n6}$, $T_{n7}$) zusammen mit einer als Bootstrap-Kapazität wirkenden Kapazität ($C_{nB}$) eine Ausgangsstufe (12) bilden und mindestens ein weiterer Transistor ($T_{n4}'$) eine Lade- und Entladestufe (11) für die Bootstrap-Kapazität ($C_{nB}$) bildet.

3. Schaltungsanordnung nach Anspruch 2, dadurch gekennzeichnet, daß sie zusätzlich einen aus einer weiteren Kapazität ($C_{n1}$) und zwei Transistoren ($T_{n1}$, $T_{n2}$) gebildeten Inverter (10) aufweist.

4. Schaltungsanordnung nach Anspruch 3, dadurch gekennzeichnet, daß die beiden Transistoren ($T_{n1}$, $T_{n2}$) des Inverters (10) nie gleichzeitig leitend sind.

5. Schaltungsanordnung nach einem der Ansprüche 1 bis 4, dadurch gekennzeichnet, daß sämtliche Transistoren ($T_{n1}$ -$T_{n11}$) als Schalter wirken.

6. Schaltungsanordnung nach einem der Ansprüche 1 bis 5, dadurch gekennzeichnet, daß die Transistoren ($T_{n1}$ - $T_{n11}$) Feldeffekt-Transistoren vom n-MOS-Anreicherungstyp sind.

7. Schaltungsanordnung nach Anspruch 6, dadurch gekennzeichnet, daß das Gate-Dielektrikum der Transistoren ($T_{n1}$ - $T_{n11}$) ein Isolator ist.

8. Verwendung einer Schaltungsanordnung nach einem der Ansprüche 1 bis 7 zur Ansteuerung von Zeilen- und/oder Spaltenleitungen von Flüssigkristall-Bildschirmen.

FIG. 1

**FIG. 2**

Zeitachse in sec $\ast 10^{-7}$

EP 0 615 250 A1

FIG. 3

FIG. 4

EP 0 615 250 A1

FIG. 5

FIG. 6

FIG.7

sec * 10$^{-7}$

13

FIG. 8

FIG. 9

FIG. 10

PHI 1

PHI 2

PHI 3

PHI 4

E(i)
= int. A(i-1)

MSi4

MSi6    MSi11

Ubi

Ci B

int. A(i)
= E(i+1)

A(i)

MSi7    MSi12

GND

VD 8

VD 7

VD 6

VD 5

VD 4

VD 3

VD 2

VD 1

MVi1  MVi2  MVi3  MVi4  MVi5  MVi6  MVi7  MVi8

i = 0.1.2 ··· (m-1)

B·i+1  B·i+2  B·i+3  B·i+4  B·i+5  B·i+6  B·i+7  B·i+8    - Spalte

16

EP 0 615 250 A1

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.5) |
|---|---|---|---|
| X | US-A-5 136 622 (D. PLUS)<br>* Zusammenfassung; Abbildungen 1,2 *<br>* Spalte 1, Zeile 53 - Spalte 3, Zeile 37 *<br>--- | 1,5,8 | G11C19/18<br>G11C19/28<br>G09G3/36 |
| X | PATENT ABSTRACTS OF JAPAN<br>vol. 9, no. 210 (P-383) (1933) 28. August 1985<br>& JP-A-60 070 599 (SEIKO DENSHI KOGYO) 22. April 1985<br>* Zusammenfassung *<br>--- | 1,2,5 | |
| A | PATENT ABSTRACTS OF JAPAN<br>vol. 8, no. 144 (P-284) 5. Juli 1984<br>& JP-A-59 042 696 (SONY) 9. März 1984<br>* Zusammenfassung *<br>--- | 1,2,5,8 | |
| A | PATENT ABSTRACTS OF JAPAN<br>vol. 8, no. 75 (P-266) 7. April 1984<br>& JP-A-58 219 525 (SUWA SEIKOSHA) 21. Dezember 1983<br>* Zusammenfassung *<br>--- | 1,2,5,8 | |
| A | PATENT ABSTRACTS OF JAPAN<br>vol. 6, no. 152 (P-134) (1030) 12. August 1982<br>& JP-A-57 069 596 (FUJITSU) 28. April 1982<br>* Zusammenfassung *<br>--- | 1,2,5 | **RECHERCHIERTE SACHGEBIETE (Int.Cl.5)**<br><br>G11C<br>G09G<br>H03K |
| A | GB-A-2 213 667 (TEXAS INSTRUMENTS)<br>* Zusammenfassung; Abbildung 1 *<br>--- | 1 | |
| A | GB-A-2 117 970 (SUWA SEIKOSHA)<br>* Zusammenfassung; Abbildungen 10-11 *<br>* Seite 5, Zeile 34 - Seite 6, Zeile 33 *<br>----- | 1,2,5,8 | |

Der vorliegende Recherchenbericht wurde für alle Patentansprüche erstellt

| Recherchenort | Abschlußdatum der Recherche | Prüfer |
|---|---|---|
| BERLIN | 25. Mai 1994 | Saam, C |